**Europäisches Patentamt**

**European Patent Office**

**Office européen des brevets**

(19)

(11) Veröffentlichungsnummer : **0 133 618**
**B1**

(12) **EUROPÄISCHE PATENTSCHRIFT**

(45) Veröffentlichungstag der Patentschrift :
08.07.87

(51) Int. Cl.⁴ : **H 03 B   5/36**

(21) Anmeldenummer : **83107491.9**

(22) Anmeldetag : **29.07.83**

(54) Monolithisch integrierte Transistor-Hochfreqzenz-Quarzoszillatorschaltung.

(43) Veröffentlichungstag der Anmeldung :
06.03.85 Patentblatt 85/10

(45) Bekanntmachung des Hinweises auf die Patenterteilung : 08.07.87 Patentblatt 87/28

(84) Benannte Vertragsstaaten :
DE FR NL

(56) Entgegenhaltungen :
VALVO-BERICHTE, Band 18, Nr. 1/2, April 1974, Seiten
15-28, Hamburg, DE. E. PECH: "Eine integrierte Synchrondemodulatorkombination für Farbfernsehempfänger"

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR NL

(72) Erfinder : Sauer, Wolfgang, Dipl.-Ing.
Eisenlohrstr. 12
D-7800 Freiburg i.Br. (DE)

(74) Vertreter : Morstadt, Volker, Dipl.-Ing.
c/o Deutsche ITT Industries GmbH Patent/Lizenzab-
teilung Postfach 840 Hans-Bunte-Strasse 19
D-7800 Freiburg/Brsg. (DE)

## Beschreibung

Die Erfindung betrifft eine monolithisch integrierte Transistor-Hochfrequenz-Quarzoszillatorschaltung mit den Merkmalen des Oberbegriffs des Patentanspruchs, wie sie in « Valvo-Berichte », April 1974, Seiten 18 bis 20 für eine Schwingfrequenz von 8,8 MHz beschrieben ist.

Bei der Auslegung dieser vorbeschriebenen Quarzoszillatorschaltung für höhere Schwingfrequenzen als 8,8 MHz, insbesondere für etwa die dopppelte Schwingfrequenz von 17,7 MHz, stellte der Erfinder fest, daß die im Verstärkerteil der Quarzoszillatorschaltung dann vorhandene Verstärkung insofern nicht mehr ausreichend ist, als am Quarz keine ausreichende Amplitude mehr auftritt. An sich könnte dieser Nachteil der vorbeschriebenen Schaltung in einfacher Weise dadurch behoben werden, daß dem Verstärkerteil eine weitere Verstärkerstufe nachgeschaltet wird. Diese Maßnahme verbietet sich jedoch bei den angegebenen Frequenzen, da unbedingt vermieden werden muß, daß unerwünschte Phasendrehungen durch nachgeschaltete Verstärkerstufen erzeugt werden.

Die Aufgabe der im Patentanspruch angegebenen Erfindung besteht daher darin, den Nachteil mangelnder Verstärkung im Verstärkungsteil der Quarzoszillatorschaltung ohne nachgeschaltete Verstärkerstufe zu beheben.

Ein Vorteil der Erfindung ist insbesondere darin zu sehen, daß ohne zusätzliche, nachgeschaltete Verstärkungsstufe eine ausreichende Verstärkung innerhalb des Verstärkungsteils der Quarzoszillatorschaltung selbst erreicht wird.

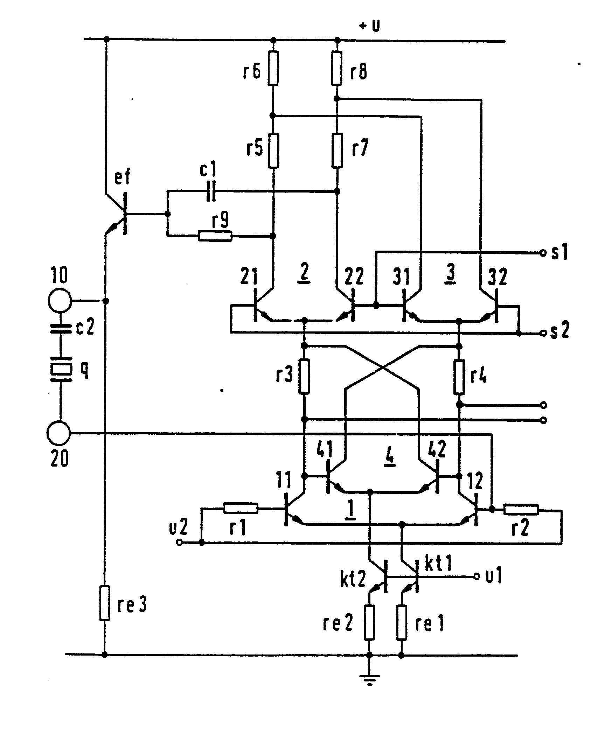

Die Erfindung wird nun anhand des in der Figur der Zeichnung dargestellten Schaltbilds eines Ausführungsbeispiels für bipolare npn-Transistoren erläutert.

Die Quarzoszillatorschaltung enthält wie üblich den Quarz q und hier den dazu in Serie liegenden zweiten Kondensator c2, der auch entfallen kann, welche Serienschaltung an zwei äußere Anschlußklemmen 10, 20 der monolithisch integrierten Oszillatorschaltung angeschlossen sind. Der integrierte Teil der Oszillatorschaltung enthält die vier Differenzverstärker 1, 2, 3, 4 mit den ihnen zugeordneten weiteren Stufen und Bauelementen. Der erste Differenzverstärker 1 mit dem ersten und dem zweiten Transistor 11, 12 sowie dem im gemeinsamen Emitterkreis dieser Transistoren angeordneten ersten Konstantstromtransistor kt1 und dem ersten und dem zweiten Widerstand r1, r2 bildet den Verstärkerteil der Oszillatorschaltung, zu dem nach der Erfindung auch der vierte Differenzverstärker mit seinem ersten und zweiten Transistor 41, 42 und dem zweiten Konstantstromtransistor kt2 gehört. Die beiden Konstantstromtransistoren kt1, kt2 liegen mit ihrem jeweiligen Emitterwiderstand re1, re2 am Schaltungsnullpunkt und mit ihrem jeweiligen Kollektor an den Emittern der Transistoren 11, 12 bzw. 41, 42, während ihre Basen an einem gemeinsamen konstanten Potential u1 angeschlossen sind. Die Werte von u1 und re1 bzw. re2 bestimmen den Wert des jeweiligen Konstantstroms.

Die Basen der Transistoren 11, 12 liegen jeweils über den ersten bzw. zweiten Widerstand r1, r2 an einem weiteren konstanten Potential u2. Die Basis des ersten Transistors 41 des vierten Differenzverstärkers 4 liegt am Kollektor des ersten Transistors 11 des ersten Differenzverstärkers 1 und in vergleichbarer Weise die Basis des Transistors 42 am Kollektor des Transistors 12. Der Kollektor des Transistors 11 bzw. der des Transistors 12 liegt über den dritten Widerstand r3 bzw. vierten Widerstand r4 an den miteinander verbundenen Emittern der Transistoren 21, 22 des zweiten Differenzverstärkers 2 bzw. an den miteinander verbundenen Emittern der Transistoren 31, 32 des dritten Differenzverstärkers 3. An den Kollektoren der Transistoren 11, 12 ist das sinusförmige Ausgangssignal der Quarzoszillatorschaltung abzunehmen. Entsprechend der Erfindung liegt nun der Kollektor des ersten Transistors 41 des vierten Differenzverstärkers 4 an den erwähnten Emittern der Transistoren 31, 32 des dritten Differenzverstärkers 3 und der Kollektor des zweiten Transistors 42 des vierten Differenzverstärkers 4 an den erwähnten Emittern der Transistoren 21, 22 des zweiten Differenzverstärkers 2.

Die Basen der Transistoren 21, 22 des zweiten Differenzverstärkers 2 und die der Transistoren 31, 32 des dritten Differenzverstärkers 3 sind über Kreuz miteinander verbunden, und es können ihnen wie beim eingangs erwähnten Stand der Technik zwei Spannungen s1, zur s2 Beeinflussung der Frequenz der Oszillatorschaltung zugeführt werden. Im einzelnen ist die Basis des ersten Transistors 21 des zweiten Differenzverstärkers 2 mit der des zweiten Transistors 32 des dritten Differenzverstärkers 3 und die Basis des zweiten Transistors 22 des zweiten Differenzverstärkers 2 mit der des ersten Transistors 31 des dritten Differenzverstärkers 3 verhunden.

Im jeweiligen Kollektorkreis der Transistoren 21, 22 des zweiten Differenzverstärkers 2 liegt die Serienschaltung aus dem fünften und dem sechsten Widerstand r5, r6 bzw. dem siebten und dem achten Widerstand r7, r8, wobei die Widerstände r6, r8 an der Betriebsspannung u liegen. Am Verbindungspunkt der Widerstände r5, r6 bzw. dem der Widerstände r7, r8 liegt der Kollektor des Transistors 31 bzw. der des Transistors 32 des dritten Differenzverstärkers 3.

Der Kollektor des Transistors 22 des Differenzverstärkers 2 liegt über den ersten Kondensator c1 an der Basis des den Emitterfolger ef bildenden Transistors ; ebenso liegt der Kollektor des Transistors 21 des Differenzverstärkers 2 über den neunten Widerstand r9 an der Basis dieses Transistors. Sein Emitter ist zu der einen erwähnten äußeren Anschlußklemme 10 geführt und liegt andererseits über den Emitterwiderstand re3 am Schaltungsnullpunkt.

Die zweite erwähnte äußere Anschlußklemme 20 ist mit der Basis des zweiten Transistors 12 des ersten Differenzverstärkers 1 verbunden.

Durch den entsprechend der Erfindung vorgesehenen vierten Differenzverstärker 4 mit zugeordnetem zweite Konstantstromtransistor kt2 wird erreicht, daß die im den zweiten und den dritten Differenzverstärker 2, 3 enthaltenden Phasenschieberteil der Oszillatorschaltung und somit auch am Quarz q auftretende Spannungsamplitude ausreichend groß ist, da der vierte Differenzverstärker 4 in den beiden Differenzverstärkern 2, 3 einen zusätzlichen Strom fließen läßt, der bei entsprechender Dimensionierung etwa genau so groß ist wie ohne den vierten Differenzverstärker 4, und somit an den Widerständen r5, r6 bzw. r7, r8 des zweiten Differenzverstärkers 2 auch ein entsprechend vergrößerter, also beispielsweise doppelt so großer, Spannungsabfall auftritt.

Obwohl das Ausführungsbeispiel, ausgehend vom eingangs erwähnten Stand der Technik, als Schaltsymbole für die Transistoren solche von Bipolar-Transistoren verwendet und auch die bevorzugte Realisierung mittels integrierter Bipolar-Transistoren erfolgt, ist die Erfindung nicht auf die Verwendung von Bipolar-Transistoren beschränkt, sondern sie kann auch mit Isolierschicht-Feldeffekttransistoren, also in der sogenannten MOS-Technik, realisiert werden. Dann können die Widerstände z. B. mittels entsprechend geschalteter MOS-Transistoren realisiert werden.

**Patentanspruch**

Monolithisch integrierte Transistor-Hochfrequenz-Quarzoszillatorschaltung mit

einem einen ersten Differenzverstärker (1) enthaltenden Verstärkerteil, in dessen Emitterkreis ein erster Konstantstromtransistor (kt1) angeordnet ist,

einem einen zweiten und einen dritten Differenzverstärker (2, 3) sowie einen ersten Kondensator (c1) enthaltenden Phasenschieberteil,

einem Emitterfolger (ef) und

einem zum Quarz (q) bei Bedarf in Serie liegenden zweiten Kondensator (c2), der am Ausgang des Emitterfolgers (ef) liegt, wobei

die Basis des ersten und die des zweiten Transistors (11, 12) des ersten Differenzverstärkers (1) jeweils über einen ersten bzw. zweiten Widerstand (r1, r2) an konstantem Potential (u2) liegen und der Quarz (q) an der Basis dieses zweiten Transistors (12) angeschlossen ist,

die Emitter des ersten und des zweiten Transistors (21, 22) des zweiten Differenzverstärkers (2) und die Emitter des ersten und des zweiten Transistors (31, 32) des dritten Differenzverstärkers (3) über einen dritten bzw. einen vierten Widerstand (r3, r4) mit dem Kollektor des ersten bzw. des zweiten Transistors (11, 12) des ersten Differenzverstärkers (1) verbunden sind, an welchen Kollektoren das sinusförmige Ausgangssignal abzunehmen ist,

im Kollektorkreis des ersten bzw. des zweiten Transistors (21, 22) des zweiten Differenzverstärkers (2) die Serienschaltung eines fünften und sechsten bzw. eines siebten und achten Widerstandes (r5, r6 ; r7, r8) liegt, mit deren jeweiligem Verbindungspunkt der Kollektor des ersten bzw. der des zweiten Transistors (31, 32) des dritten Differenzverstärkers (3) verbunden ist,

der erste Kondensator (c1) zwischen dem Kollektor des zweiten Transistors (22) des zweiten Differenzverstärkers (2) und dem Eingang des Emitterfolgers (ef) und ein neunter Widerstand (r9) zwischen dem Kollektor des ersten Transistors (21) des zweiten Differenzverstärkers (2) und diesem Eingang liegt und

die Basis des ersten Transistors (21) bzw. die des zweiten Transistors (22) des zweiten Differenzverstärkers (2) mit der Basis des zweiten bzw. der des ersten Transistors (32, 31) des dritten Differenzverstärkers (3) verbunden ist, gekennzeichnet durch folgende Merkmale :

im Emitterkreis eines dem Verstärkerteil zugeordneten vierten Differenzverstärkers (4) liegt ein zweiter Konstantstromtransistor (kt2), dessen Basis am selben Potential (u1) wie die des ersten Konstantstromtransistors (kt1) angeschlossen ist,

die Basis des ersten bzw. die des zweiten Transistors (41, 42) des vierten Differenzverstärkers (4) ist mit dem Kollektor des ersten bzw. dem des zweiten Transistors (11, 12) des ersten Differenzverstärkers (1) verbunden, und

der Kollektor des ersten bzw. der des zweiten Transistors (41, 42) des vierten Differenzverstärkers (4) liegt an den Emittern der Transistoren (31, 32 ; 21, 22) des dritten bzw. des zweiten Differenzverstärkers (3, 2).

**Claim**

Monolithic integrated transistor HF crystal oscillator circuit comprising

an amplifier section containing a first differential amplifier (1), in the emitter circuit of which a first constant current transistor (kt1) is arranged,

a phase shifting section containing a second and a third differential amplifier (2, 3), as well as a first capacitor (c1),

an emitter follower (ef) and

a second capacitor (c2) which, if so required, is arranged in series with the crystal (q), with said second capacitor (c2) being arranged at the output of said emitter follower (ef), with

the base electrode of the first and that of the second transistor (11, 12) of the first differential amplifier (1) each being connected, across a first or a second resistor (r1, r2) to a constant potential (u2), with said crystal (q) being connected to the base electrode of said second transistor (12),

the emitter of the first and that of the second transistor (21, 22) of said second differential amplifier (2) and the emitters of the first and the second transistor (31, 32) of said third differential amplifier (3) being connected across a third or a fourth resistor (r3, r4) to the collector of the first or the second transistor (11, 12) of said first differential amplifier (1), with the sinusoidal output signal capable of being taken off said collectors,

the series arrangement of a fifth and sixth or a seventh and eighth resistor (r5, r6 ; r7, r8) being arranged in the collector circuit of the first or the second transistor (21, 22) of said second differential amplifier (2) respectively, to the respective junction point of which the collector of the first or that of the second transistor (31, 32) of said third differential amplifier (3) is connected,

the first capacitor (c1) being arranged between the collector of the second transistor (22) of the second differential amplifier (2) and the input of said emitter follower (ef), and with a ninth resistor (r9) being arranged between the collector of the first transistor (21) of said second differential amplifier (2) and this input, and

the base electrode of said first transistor (21) or that of said second transistor (22) of said second differential amplifier (2) being connected to the base electrode of the second or to that of the first transistor (32, 31) of said third differential amplifier (3),

characterized by the following features :

in the emitter circuit of a fourth differential amplifier (4) associated with the amplifier section, there is arranged a second constant current transistor (kt2) whose base electrode is connected to the same potential (u1) as that of said first constant current transistor (kt1),

the base electrode of the first or that of the second transistor (41, 42) of the fourth differential amplifier (4) is connected to the collector of the first or to that of the second transistor (11, 12) of said first differential amplifier (1), and

the collector of the first or that of the second transistor (41, 42) of the fourth differential amplifier (4) is connected to the emitters of the transistors (31, 32 ; 21, 22) of said third or said second differential amplifier (3, 2).

**Revendication**

Circuit oscillateur haute-fréquence à cristal, à intégration monolithique comprenant :

une section d'amplificateur contenant un premier amplificateur différentiel (1) dans le circuit d'émetteur duquel est disposé un premier transistor à courant constant (kt1),

une section de déphasage contenant un deuxième et un troisième amplificateurs différentiels (2, 3), ainsi qu'un premier condensateur (c1),

un montage à émetteur suiveur (ef) et

un deuxième condensateur (c2) connecté si nécessaire en série avec le cristal (q), disposé à la sortie du montage à émetteur suiveur (ef), de sorte que

la base du premier et celle du deuxième transistor (11, 12) du premier amplificateur différentiel (1) sont connectées chacune, par une première et une deuxième résistance (r1, r2) respectivement, à un potentiel constant (u2) et le cristal est connecté à l'électrode de base du deuxième transistor (12),

l'émetteur du premier et celui du deuxième transistor (21, 22) du deuxième amplificateur différentiel (2) et l'émetteur du premier et celui du deuxième transistor (31, 32) du troisième amplificateur différentiel (3) sont connectés, par une troisième et une quatrième résistance (r3, r4) respectivement, aux collecteurs des premier et deuxième transistors (11, 12) respectivement du premier amplificateur différentiel (1) collecteurs sur lesquels est prélevé le signal de sortie sinusoïdal,

les circuits série d'une cinquième et d'une sixième résistance et d'une septième et d'une huitième résistance (r5, r6 ; r7, r8) sont connectés dans les circuits de collecteur du premier et du deuxième transistor (21, 22) respectivement, tandis que les collecteurs des premier et deuxième transistors (31, 32) du troisième amplificateur différentiel (3) sont respectivement connectés aux points de raccordement de ces circuits série,

le premier condensateur (c1) est connecté entre le collecteur du deuxième transistor (22) du deuxième amplificateur différentiel (2) et l'entrée du montage à émetteur suiveur (ef) et une neuvième résistance (r9) est connectée entre le collecteur du premier transistor (21) du deuxième amplificateur différentiel (2) et cette entrée,

la base du premier transistor (21) et celle du deuxième transistor (22) du deuxième amplificateur différentiel (2) sont respectivement connectées aux bases des deuxième et premier transistors (32, 31) du troisième amplificateur différentiel,

caractérisé en ce que :

dans le circuit d'émetteur d'un quatrième amplificateur différentiel (4) disposé dans la partie d'amplificateur est inclus un deuxième transistor à courant constant (kt2) dont l'électrode de base est connectée au même potentiel (u1) que celle du premier transistor à courant constant (kt1),

la base du premier et celle du deuxième transistor (41, 42) du quatrième amplificateur différentiel (4) sont respectivement couplées aux collecteurs des premier et deuxième transistors (11, 12) du premier amplificateur différentiel (1), et

le collecteur du premier et celui du deuxième transistor (41, 42) du quatrième amplificateur différentiel (4) sont connectés aux émetteurs des transistors (31, 32 ; 21, 22) des troisième et deuxième amplificateur différentiel (3, 2).